# FASCICULE DE BREVET EUROPEEN

(11) **EP 3 579 028 B1**
(45) Date de publication et mention de la délivrance du brevet: **03.08.2022**
(21) Numéro de dépôt: 19178271.3
(22) Date de dépôt: 04.06.2019
(51) Int. Cl.: G02B 5/20, G02B 5/28

(54) **CAPTEURS D'IMAGES COMPRENANT UNE MATRICE DE FILTRES INTERFÉRENTIELS**
BILDSENSOREN MIT EINER MATRIX VON INTERFERENZFILTERN
IMAGE SENSORS COMPRISING A MATRIX OF INTERFERENTIAL FILTERS

(30) Priorité: 08.06.2018 FR 1800585
(43) Date de publication de la demande: 11.12.2019
(73) Titulaire: Commissariat à l'Energie Atomique et aux Energies Alternatives, 75015 Paris (FR)
(72) Inventeur: FREY, Laurent, 38054 GRENOBLE CEDEX 09 (FR); MASAROTTO, Lilian, 38054 GRENOBLE CEDEX 09 (FR)
(74) Mandataire: Cabinet Beaumont

(56) Documents cités:
- WO-A1-2012/004934
- US-A1- 2015 212 245
- US-A1- 2015 219 958

## Description

### Domaine

La présente demande concerne un filtre interférentiel, notamment pour un capteur d'images, et un procédé de fabrication d'un tel filtre interférentiel.

### Exposé de l'art antérieur

Il est connu de réaliser des matrices de filtres interférentiels, en particulier pour les capteurs d'images, également appelés imageurs, dans le domaine du visible, de l'infra-rouge (notamment pour des longueurs d'onde de 650 nm à 1050 nm) et/ou de l'ultraviolet, qui nécessitent de séparer plusieurs plages de fréquences. Une telle matrice de filtres est également appelée filtre pixellisé, un pixel de filtre, ou filtre élémentaire, correspondant au plus petit élément du filtre ayant les mêmes propriétés de filtrage.

Un exemple d'application d'un filtre pixélisé correspond à un dispositif comprenant un capteur adapté à faire l'acquisition d'images couleurs et d'images infrarouges. Le filtre pixélisé peut alors comprendre des premiers pixels de filtre laissant passer la lumière visible et bloquant le rayonnement infrarouge et des deuxièmes pixels de filtre laissant passer le rayonnement infrarouge, notamment le proche infrarouge, et bloquant la lumière visible.

Un filtre interférentiel est réalisé par un empilement de plusieurs couches. A titre d'exemple, un filtre interférentiel peut comprendre un empilement de couches semi-réfléchissantes métalliques séparées par des couches diélectriques et/ou une alternance de couches diélectriques ayant des indices de réfraction différents, également appelés indices optiques par la suite. Les épaisseurs des couches du filtre dépendent des propriétés de filtrage souhaitées.

La réalisation d'un filtre pixélisé requiert la réalisation de couches diélectriques ayant des épaisseurs différentes selon le pixel de filtre considéré.

Un exemple de procédé de fabrication d'un filtre pixélisé est décrit dans le document WO2015195123 et met en oeuvre un procédé par décollement (en anglais "lift-off"). Un inconvénient d'un tel procédé est qu'il requiert des espaceurs, ou zones de transition, entre pixels de filtre voisins d'environ deux fois l'épaisseur totale du filtre. Un tel procédé ne peut donc pas être mis en oeuvre avec des matrices de pixels adjacents et de petite taille, typiquement 3 µm-5 µm. En effet, l'épaisseur totale des filtres multicouches est d'au moins 1 µm à 2 µm pour obtenir des réponses spectrales suffisamment sélectives dans les applications d'imagerie couleur et infrarouge.

Un inconvénient est que si une partie de la lumière parvient sur les zones de transition, cela entraîne une perte de signal par diffusion et/ou une distorsion des réponses spectrales des pixels de filtre. Ces pertes peuvent devenir importantes lorsque la largeur des espaceurs n'est pas négligeable par rapport à la dimension latérale, ou taille, du pixel de filtre. Ceci peut notamment se produire dans le cas de petits pixels de filtre, dont la dimension latérale est inférieure à 2 µm, même lorsque les couches du filtre interférentiel ont une épaisseur de quelques centaines de nanomètres. Ceci peut également se produire pour des pixels de filtre plus gros, dont la dimension latérale est supérieure à 2 µm, avec des couches du filtre interférentiel ayant une épaisseur de quelques micromètres. Le document US 2015/212245 A1 divulgue un filtre interférentiel pixélisé destiné à reposer sur un support.

### Résumé

Un objet d'un mode de réalisation est de pallier tout ou partie des inconvénients des filtres interférentiels et de leurs procédés de fabrication décrits précédemment.

Un autre objet d'un mode de réalisation est que les dimensions latérales des espaceurs du filtre interférentiel sont réduites, voire que le filtre interférentiel ne comprend pas d'espaceur entre les pixels de filtre.

Un autre objet d'un mode de réalisation est la réalisation d'un filtre interférentiel pixélisé avec une taille de pixel de filtre inférieure à 5 µm, de préférence comprise entre 3 µm et 4 µm, plus préférentiellement comprise entre 1,5 µm et 3 µm.

Ainsi, un mode de réalisation prévoit un filtre pixélisé destiné à reposer sur un support et comprenant, selon une direction d'empilement :
des premiers pixels de filtre comprenant chacun un premier filtre interférentiel recouvert d'un premier bloc diélectrique ; et
des deuxièmes pixels de filtre comprenant chacun un deuxième bloc diélectrique, dont l'épaisseur est supérieure ou égale à l'épaisseur du premier filtre interférentiel, recouvert d'un deuxième filtre interférentiel, dont l'épaisseur est inférieure ou égale à l'épaisseur du premier bloc diélectrique,
dans lequel, pour au moins l'un des deuxièmes pixels de filtre, le deuxième bloc diélectrique du deuxième pixel de filtre est interposé entre les premiers filtres interférentiels de deux premiers pixels de filtre et le deuxième filtre interférentiel du deuxième pixel de filtre est interposé entre les premiers blocs diélectriques des deux premiers pixels de filtre,
le filtre pixélisé comprenant, entre chaque paire de premier et deuxième pixels de filtre adjacents, une zone de transition dont la dimension minimale entre le premier pixel de filtre et le deuxième pixel de filtre de ladite paire, perpendiculairement à la direction d'empilement, est inférieure à 500 nm,
et dans lequel le filtre pixélisé comprend des première et deuxième faces opposées, la première face étant au contact du support et la deuxième face étant sensiblement plane.

Selon un mode de réalisation, chaque premier filtre interférentiel comprend une alternance de premières couches diélectriques d'un premier matériau diélectrique ayant un premier indice de réfraction dans le domaine visible et de deuxièmes couches diélectriques d'un deuxième matériau diélectrique ayant un deuxième indice de réfraction dans le domaine visible strictement inférieur au premier indice de réfraction et chaque deuxième filtre interférentiel comprend une alternance de troisièmes couches diélectriques d'un troisième matériau diélectrique ayant un troisième indice de réfraction dans le domaine infrarouge et de quatrièmes couches diélectriques d'un quatrième matériau diélectrique ayant un quatrième indice de réfraction dans le domaine infrarouge strictement inférieur au troisième indice de réfraction ou chaque premier filtre interférentiel comprend une alternance des troisièmes couches diélectriques et des quatrièmes couches diélectriques et dans lequel chaque deuxième filtre interférentiel comprend une alternance des premières couches diélectriques et des deuxièmes couches diélectriques.

Selon un mode de réalisation, le premier matériau diélectrique peut être choisi dans le groupe comprenant le nitrure de silicium (SiN), l'oxyde d'hafnium (HfOₓ), l'oxyde d'aluminium (AlOₓ), un alliage d'aluminium, d'oxygène et d'azote (AlOₓN_{y}), un alliage de silicium, d'oxygène, de carbone et d'azote (SiOₓC_{y}N_{z}), le nitrure de silicium (SiNₓ), l'oxyde de niobium (NbOₓ), l'oxyde de tantale (TaOₓ), l'oxyde de titane (TiOₓ) et les mélanges d'au moins deux de ces composés.

Selon un mode de réalisation, le deuxième matériau diélectrique et/ou le quatrième matériau diélectrique peuvent être chacun choisis dans le groupe comprenant le dioxyde de silicium (SiO₂), le fluorure de magnésium (MgF₂), l'oxyde de silicium (SiOₓ), l'oxynitrure de silicium (SiOₓN_{y}), l'oxyde d'hafnium (HfOₓ), l'oxyde d'aluminium (AlOₓ), un film à base d'aluminium, d'oxygène et d'azote (AlOₓN_{y}), un film à base de silicium, d'oxygène, de carbone et d'azote (SiOₓC_{y}N_{z}), le nitrure de silicium (SiNₓ) et les mélanges d'au moins deux de ces composés.

Selon un mode de réalisation, le le troisième matériau diélectrique peut être choisi dans le groupe comprenant le silicium amorphe (aSi), le silicium amorphe hydrogéné (aSiH) et les mélanges de ces composés.

Un mode de réalisation prévoit également un capteur d'images comprenant un support et le filtre pixélisé tel que défini précédemment reposant sur le support.

Selon un mode de réalisation, le capteur comprend, en outre, une couche antireflet entre le support et le filtre pixélisé.

Selon un mode de réalisation, le capteur comprend, pour chaque premier pixel de filtre et recouvrant ledit premier pixel de filtre, au moins un filtre coloré adapté à laisser passer la lumière visible seulement dans une première plage de longueurs d'onde et un filtre coloré adapté à laisser passer la lumière visible seulement dans une deuxième plage de longueurs d'onde différentes de la première plage.

Selon un mode de réalisation, le capteur comprend, pour chaque filtre coloré de chaque premier pixel de filtre, une première lentille recouvrant ledit filtre coloré, et comprend, pour chaque deuxième pixel de filtre, une deuxième lentille recouvrant le deuxième pixel de filtre.

Un mode de réalisation prévoit un procédé de fabrication d'un filtre interférentiel tel que défini précédemment, comprenant les étapes successives suivantes :
a) dépôt, sur un substrat, d'un premier empilement de couches diélectriques ayant la structure des premiers filtres interférentiels ;
b) gravure du premier empilement pour retirer le premier empilement aux emplacements des deuxièmes pixels de filtres et conserver les premiers filtres interférentiels aux emplacements des premiers pixels de filtre ;
c) dépôt d'une première couche isolante, ayant une épaisseur supérieure à l'épaisseur du premier empilement, sur les premiers filtres interférentiels et entre les premiers filtres interférentiels ;
d) gravure d'au moins une partie de la première couche isolante sur les premiers filtres interférentiels ;
e) dépôt d'un deuxième empilement de couches diélectriques ayant la structure des deuxièmes filtres interférentiels ;
f) gravure du deuxième empilement pour retirer le deuxième empilement aux emplacements des premiers pixels de filtres et conserver les deuxièmes filtres interférentiels aux emplacements des deuxièmes pixels de filtre ;
g) dépôt d'une deuxième couche isolante, ayant une épaisseur supérieure à l'épaisseur du deuxième empilement, sur les deuxièmes filtres interférentiels et entre les deuxièmes filtres interférentiels ; et
h) gravure d'au moins une partie de la deuxième couche isolante sur les deuxièmes filtres interférentiels.

Selon un mode de réalisation, à l'étape a), le premier empilement est déposé sur un support comprenant au moins une zone en relief, le procédé comprenant, à l'étape b), la gravure de la partie du premier empilement recouvrant la zone en relief.

Selon un mode de réalisation, la gravure de la première couche isolante et/ou de la deuxième couche isolante comprend une étape de polissage mécano-chimique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 et 2 sont respectivement une vue en coupe et une vue de dessus, partielles et schématiques, d'un mode de réalisation d'un dispositif optoélectronique comprenant un filtre interférentiel ;
les figures 3 à 6 représentent chacune, en partie gauche, une carte du module du vecteur de Poynting dans une vue en coupe d'un dispositif optoélectronique comprenant un pixel de filtre et, en partie droite, une courbe d'évolution de la transmission du pixel de filtre en fonction de la longueur d'onde pour différentes structures de pixels de filtre et de micro-lentilles ;
la figure 7 représente des domaines correspondant à des structures acceptables de pixels de filtre en fonction du rayon de courbure de la lentille recouvrant le pixel de filtre et de la distance entre le support sur lequel repose le pixel de filtre et la lentille ;
les figures 8 et 9 sont des vues en coupe, partielles et schématiques, d'autres modes de réalisation d'un filtre interférentiel ;
les figures 10A à 10H sont des vues en coupe, partielles et schématiques, de structures obtenues à des étapes successives d'un mode de réalisation d'un procédé de fabrication du dispositif optoélectronique représenté sur les figures 1 et 2 ;
les figures 11A à 11D sont des vues en coupe, partielles et schématiques, de structures obtenues à des étapes successives d'un procédé non satisfaisant de fabrication du dispositif optoélectronique représenté sur les figures 1 et 2 en présence de reliefs ;
les figures 12A à 12K sont des vues en coupe, partielles et schématiques, de structures obtenues à des étapes successives d'un mode de réalisation d'un procédé de fabrication du dispositif optoélectronique représenté sur les figures 1 et 2 en présence de reliefs ;
les figures 13 à 17 sont des vues en coupe, partielles et schématiques, d'autres modes de réalisation d'un dispositif optoélectronique comprenant un filtre interférentiel ;
la figure 18 est une vue de dessus, partielle et schématique, du dispositif optoélectronique représenté sur les figures 16 ou 17 ; et
les figures 19 à 21 sont des vues en coupe, partielles et schématiques, d'autres modes de réalisation d'un dispositif optoélectronique comprenant un filtre interférentiel.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de traitement des signaux fournis par les capteurs décrits ci-après sont à la portée de l'homme de l'art et ne sont pas décrits. Dans la suite de la description, sauf indication contraire, les termes "approximativement", "sensiblement", "environ" et "de l'ordre de" signifient "à 10 % près", de préférence "à 5 % près". De plus, une surface "sensiblement plane" est une surface ne présentant pas zones en relief ou en creux ayant une épaisseur supérieure à 500 nm par rapport au plan moyen de la surface. En outre, dans la suite de la description, on appelle taille ou dimension latérale d'un élément d'un capteur, la dimension maximale de cet élément dans un plan perpendiculaire à la direction d'empilement des couches formant le capteur.

Dans la suite de la description, l'indice de réfraction du matériau signifie l'indice de réfraction du matériau sur la plage de longueurs d'onde de fonctionnement du filtre interférentiel dans le cas où l'indice de réfraction du matériau est sensiblement constant sur la plage de longueurs d'onde de fonctionnement du filtre interférentiel, ou signifie l'indice de réfraction moyen du matériau sur la plage de longueurs d'onde de fonctionnement du filtre interférentiel dans le cas où l'indice de réfraction du matériau varie sur la plage de longueurs d'onde de fonctionnement du filtre interférentiel. De plus, dans la suite de la description, on appelle "filtre coloré" une couche homogène faite d'un seul matériau, par exemple une résine organique, ayant des propriétés de filtrage spectral par absorption sélective de la lumière dans le volume du matériau. En outre, on appelle "lumière visible" ou "domaine visible" un rayonnement dont les longueurs d'onde sont comprises entre environ 400 nm et environ 700 nm.

Dans la suite de la description, on appelle "zone de transition" ou "espaceur" entre deux pixels de filtre adjacents du filtre pixélisé, la région entre les deux pixels de filtre dans laquelle la performance du filtre pixélisé ne peut pas être garantie à cause des incertitudes de fabrication, essentiellement le désalignement lors d'étapes de lithographie et l'inclinaison des flancs résultant d'une étape de gravure. En particulier, la zone de transition peut inclure une zone de recouvrement de deux filtres interférentiels, une zone sans filtre interférentiel si les filtres interférentiels sont un peu espacés, et/ou les bords inutilisables de chaque filtre interférentiel, pouvant comprendre des faces pas tout à fait verticales.

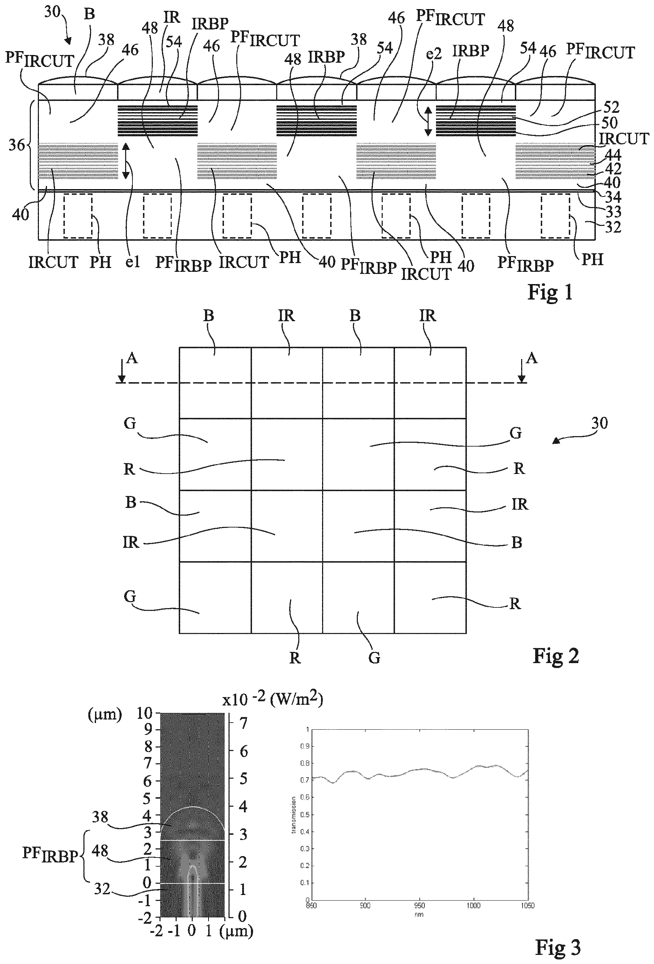

Les figures 1 et 2 représentent un mode de réalisation d'un dispositif optoélectronique 30 correspondant à un capteur d'image, la figure 1 étant une coupe de la figure 2 selon la ligne A-A. Le dispositif optoélectronique 30 comprend un support 32, par exemple en silicium, une structure monocouche ou multicouches antireflet 34 recouvrant la face supérieure 33 du support 32 et un filtre interférentiel pixélisé 36 reposant sur la couche antireflet 34.

Le support 32 peut comprendre des capteurs de photons ou photodétecteurs PH, représentés de façon très schématique en figure 1 par des carrés en pointillés. Le dispositif optoélectronique 30 peut en outre comprendre des filtres colorés, notamment des filtres rouges R, des filtres verts G, des filtres bleus B, et des filtres infrarouges IR, reposant sur le filtre interférentiel pixélisé 36. Le dispositif optoélectronique 30 peut en outre comprendre des lentilles 38, représentées seulement sur la figure 1, recouvrant les filtres colorés R, G, B, IR.

Dans le présent mode de réalisation, le filtre interférentiel 36 comprend des premiers et deuxièmes pixels de filtre PF_{IRBP} et PF_{IRCUT}.

Dans le présent mode de réalisation, chaque premier pixel de filtre PF_{IRCUT} comprend du bas vers le haut en figure 1 :
éventuellement une couche diélectrique 40 ;
un premier filtre interférentiel IRCUT ayant une épaisseur e₁ et comprenant une alternance de couches 42 d'un premier matériau diélectrique ayant un indice de réfraction haut n_{H1} et de couches 44 d'un deuxième matériau diélectrique ayant un indice de réfraction bas n_{B1}, inférieur strictement à l'indice de réfraction n_{H1}, les couches 42 pouvant ne pas avoir les mêmes épaisseurs et les couches 44 pouvant ne pas avoir les mêmes épaisseurs ; et
un bloc diélectrique 46, qui peut avoir une structure monocouche ou multicouches.

Dans le présent mode de réalisation, chaque deuxième pixel de filtre PF_{IRBP} comprend du bas vers le haut en figure 1 :
un bloc diélectrique 48 ayant une épaisseur supérieure ou égale à l'épaisseur e₁, le bloc 48 pouvant avoir une structure monocouche ou multicouches;
un deuxième filtre interférentiel IRBP ayant une épaisseur e₂ inférieure ou égale à l'épaisseur du bloc 46 et comprenant une alternance de couches 50 d'un troisième matériau diélectrique ayant un indice de réfraction haut n_{H2} et de couches 52 d'un quatrième matériau diélectrique ayant un indice de réfraction bas n_{B2}, inférieur strictement à l'indice de réfraction n_{H2}, les couches 50 pouvant ne pas avoir les mêmes épaisseurs et les couches 52 pouvant ne pas avoir les mêmes épaisseurs ; et
éventuellement une couche diélectrique 54.

Selon un mode de réalisation, les deuxième et quatrième matériaux sont identiques. La couche diélectrique 40 est en un cinquième matériau diélectrique. Le bloc diélectrique 46 est en au moins un sixième matériau diélectrique. Le bloc diélectrique 48 est en au moins un septième matériau diélectrique. La couche diélectrique 54 est en un huitième matériau diélectrique. Dans le mode de réalisation représenté sur la figure 1, les cinquième, sixième, septième et huitième matériaux diélectriques sont identiques au matériau de bas indice de réfraction des filtres interférentiels IRCUT et IRBP, c'est-à-dire identiques aux deuxième et quatrième matériaux. Pour cette raison, sur les figures, les couches diélectriques d'indice de réfraction bas ne sont pas représentées de façon distincte. A titre de variante, les cinquième, sixième, septième et/ou huitième matériaux diélectriques peuvent être différents des deuxième et quatrième matériaux. Toutefois, de préférence, les cinquième, sixième, septième et/ou huitième matériaux diélectriques sont en un matériau ou en des matériaux d'indices de réfraction voisins du matériau de bas indice de réfraction des filtres interférentiels IRCUT et IRBP avec un écart d'indice de réfraction inférieur à 0,1.

Selon un mode de réalisation, les premiers pixels de filtre PF_{IRCUT} transmettent la lumière visible et ne transmettent sensiblement pas le rayonnement infrarouge pour des longueurs d'onde supérieures à un seuil compris entre 630 nm et 750 nm. Selon un mode de réalisation, les deuxièmes pixels de filtre PF_{IRBP} transmettent essentiellement un rayonnement infrarouge dans une seule plage de longueurs d'onde dont la largeur est comprise entre 10 nm et 100 nm.

Les couches diélectriques 42, 44, 50, 52 des filtres IRCUT et IRBP sont sensiblement planes. De préférence, les filtres IRCUT et IRBP ne comprennent pas d'espaceurs.

Les photodétecteurs PH peuvent être adaptés à détecter des rayonnements dans des plages de longueurs d'onde différentes ou être adaptés à détecter des rayonnements dans la même plage de longueurs d'onde. Dans ce dernier cas, c'est seulement la présence des pixels de filtre PF_{IRCUT} et PF_{IRBP} et des filtres colorés R, G, B et IR qui permet la détection de rayonnements dans des plages de longueurs d'onde différentes. Chaque pixel de filtre peut alors recouvrir au moins un photodétecteur du capteur et jouer le rôle d'un filtre passe-bande du rayonnement incident qui atteint le capteur pour fournir un rayonnement adapté à la plage de longueurs d'onde détectées par le photodétecteur associé. Les dimensions latérales des pixels de filtre peuvent être sensiblement égales aux dimensions latérales des photosites du capteur d'images ou égales à un multiple des dimensions latérales des photosites du capteur d'images. La disposition des pixels de filtre et des filtres colorés peut suivre celle des photosites du capteur d'images. A titre d'exemple, les pixels de filtre et les filtres colorés peuvent être disposés en carré comme cela est représenté en figure 2. Le filtre interférentiel 36 peut notamment être utilisé avec des capteurs d'images dont les photosites ont une taille inférieure à 5 µm. Le capteur d'images peut être un capteur couleur et infrarouge.

Selon un mode de réalisation, chaque premier pixel de filtre PF_{IRCUT} est recouvert par au moins deux filtres colorés parmi les filtres R, G, B laissant passer la lumière visible dans des plages de longueurs d'onde différentes. Selon un mode de réalisation, chaque deuxième pixel de filtre PF_{IRBP} est recouvert par un seul filtre coloré IR laissant passer le rayonnement infrarouge. Selon un mode de réalisation, le dispositif optoélectronique 30 comprend des premiers filtres colorés R recouvrant les premiers pixels de filtre PF_{IRCUT} et, pour la lumière visible, ne laissant passer que les longueurs d'onde dans le rouge, notamment les longueurs d'onde comprises entre 580 nm et 700 nm. Selon un mode de réalisation, le dispositif optoélectronique 30 comprend des deuxièmes filtres colorés G recouvrant les premiers pixels de filtre PF_{IRCUT} et, pour la lumière visible, ne laissant passer que les longueurs d'onde dans le vert, notamment les longueurs d'onde comprises entre 470 nm et 590 nm. Selon un mode de réalisation, le dispositif optoélectronique 30 comprend des troisièmes filtres coloré B recouvrant les premiers pixels de filtre PF_{IRCUT} et, pour la lumière visible, ne laissant passer que les longueurs d'onde dans le bleu, notamment les longueurs d'onde comprises entre 380 nm et 500 nm. Selon un mode de réalisation, le dispositif optoélectronique 30 comprend des quatrièmes filtres coloré IR recouvrant les deuxièmes pixels de filtre PF_{IRBP} et ne laissant pas passer la lumière visible, et laissant notamment passer un rayonnement de longueurs d'onde comprises entre 750 nm et 3000 nm.

Les épaisseurs e₁ et e₂ peuvent être comprises entre 0,5 µm et 4 µm, de préférence entre 1 µm et 3 µm.

Selon un mode de réalisation, le premier matériau diélectrique est transparent, c'est-à-dire avec un coefficient d'extinction inférieur à 5.10⁻³, dans le domaine visible et le proche infrarouge. Selon un mode de réalisation, le deuxième matériau diélectrique est transparent, c'est-à-dire avec un coefficient d'extinction inférieur à 5.10⁻³, dans le domaine visible et le proche infrarouge. Selon un mode de réalisation, le troisième matériau diélectrique est transparent, c'est-à-dire avec un coefficient d'extinction inférieur à 5.10⁻³, dans le domaine visible et le proche infrarouge.

L'indice de réfraction n_{H1} peut être compris entre 1,8 et 2,5. L'indice de réfraction n_{B1} ou n_{B2} peut être compris entre 1,3 et 2,5. L'indice de réfraction n_{H2} peut être compris entre 1,8 et 4,5.

Le premier matériau diélectrique peut être choisi dans le groupe comprenant le nitrure de silicium (SiN), l'oxyde d'hafnium (HfOₓ), l'oxyde d'aluminium (AlOₓ), un alliage d'aluminium, d'oxygène et d'azote (AlOₓN_{y}), un alliage de silicium, d'oxygène, de carbone et d'azote (SiOₓC_{y}N_{z}), le nitrure de silicium (SiNₓ), l'oxyde de niobium (NbOₓ), l'oxyde de tantale (TaOₓ), l'oxyde de titane (TiOₓ) et les mélanges d'au moins deux de ces composés.

Le deuxième matériau diélectrique et le quatrième matériau diélectrique peuvent être chacun choisis dans le groupe comprenant le dioxyde de silicium (SiO₂), le fluorure de magnésium (MgF₂), l'oxyde de silicium (SiOₓ), l'oxynitrure de silicium (SiOₓN_{y}), l'oxyde d'hafnium (HfOₓ), l'oxyde d'aluminium (AlOₓ), un film à base d'aluminium, d'oxygène et d'azote (AlOₓN_{y}), un film à base de silicium, d'oxygène, de carbone et d'azote (SiOₓC_{y}N_{z}), le nitrure de silicium (SiNₓ) et les mélanges d'au moins deux de ces composés.

Le troisième matériau diélectrique peut être choisi dans le groupe comprenant le silicium amorphe (aSi), le silicium amorphe hydrogéné (aSiH) et les mélanges de ces composés.

De façon avantageuse, le filtre pixélisé comprend, entre chaque paire de premier et deuxième pixels de filtre adjacents, une zone de transition dont la dimension minimale entre le premier pixel PF_{IRCUT} de filtre et le deuxième pixel de filtre PF_{IRBP} de ladite paire, perpendiculairement à la direction d'empilement du dispositif, est inférieure à 500 nm.

La figure 3 représente, en partie gauche, une carte de chaleur en niveaux de gris du module du vecteur de Poynting qui représente le flux d'énergie électromagnétique dans une vue en coupe d'une partie du dispositif optoélectronique 30 dans le cas où le pixel de filtre PF_{IRBP} comprend seulement le bloc diélectrique 48 entre le support 32 en silicium et la lentille 38. La figure 3 représente, en partie droite, une courbe d'évolution de la transmission du rayonnement par la structure comprenant le pixel de filtre et la lentille en fonction de la longueur d'onde. Pour un photosite ayant, en vue de dessus, une forme carrée de 4 µm de côté et ayant une zone active de collecte du rayonnement incident de forme carrée de 2 µm de côté, on obtient une collecte efficace du rayonnement incident dans la zone active lorsque l'épaisseur du bloc diélectrique 48 est de l'ordre de 2,5 µm et le rayon de courbure de la lentille 38 est égal à 2 µm. Il apparaît que la lentille 38 focalise la lumière approximativement au niveau de la surface du support 32 de silicium. La transmission varie peu en fonction de la longueur d'onde et est de l'ordre de 75 %.

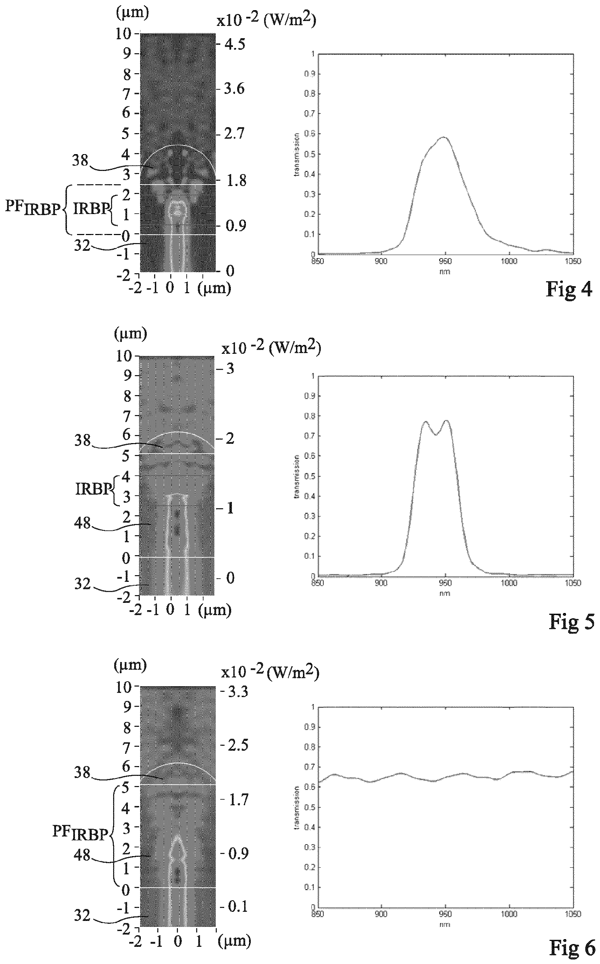

La figure 4 est une figure analogue à la figure 3 dans le cas où le filtre interférentiel IRBP du pixel de filtre PF_{IRBP} est agencé à mi-chemin entre le support 32 et la lentille 38, l'écart entre le support 32 et la lentille 38 étant égal à 2,5 µm et le rayon de courbure de la lentille 38 étant égal à 2 µm. On observe bien un filtrage des longueurs d'onde avec néanmoins une diminution de la transmission maximale par rapport au cas représenté en figure 3. En outre, la sélectivité spectrale obtenue est relativement médiocre avec par exemple une transmission non négligeable vers 1000 nm.

La figure 5 est une figure analogue à la figure 4 dans le cas où le filtre interférentiel IRBP du pixel de filtre PF_{IRBP} est prévu entre le support 32 et la lentille 38, l'écart entre le support 32 et la lentille 38 étant égal à 5 µm et le rayon de courbure de la lentille 38 étant égal à 2,5 µm. Il apparaît une augmentation de la transmission maximale de la structure aux longueurs d'onde d'intérêt par rapport à la figure 4 lorsque le filtre interférentiel IRBP est présent mais que l'écart entre le support 32 et la lentille 38 est de 2,5 µm. La transmission maximale est proche du cas où il n'y a pas de filtre interférentiel IRBP et où l'écart entre le support 32 et la lentille 38 est de 2,5 µm. L'effet est obtenu indépendamment de l'écart entre le filtre interférentiel IRBP et le support 32.

La figure 6 est une figure analogue à la figure 4 lorsque le pixel de filtre PF_{IRBP} comprend seulement le bloc diélectrique 48 entre le support 32 et la lentille 38, l'écart entre le support 32 et la lentille 38 étant égal à 5 µm et le rayon de courbure de la lentille 38 étant égal à 2,5 µm. La transmission varie peu en fonction de la longueur d'onde et est de l'ordre de 65 %, c'est-à-dire inférieure au cas illustré en figure 3. Par rapport à la figure 5, il apparaît de façon surprenante que la transmission aux longueurs d'onde d'intérêt lorsque le filtre interférentiel IRBP est présent est plus importante que lorsque le filtre IRBP est absent.

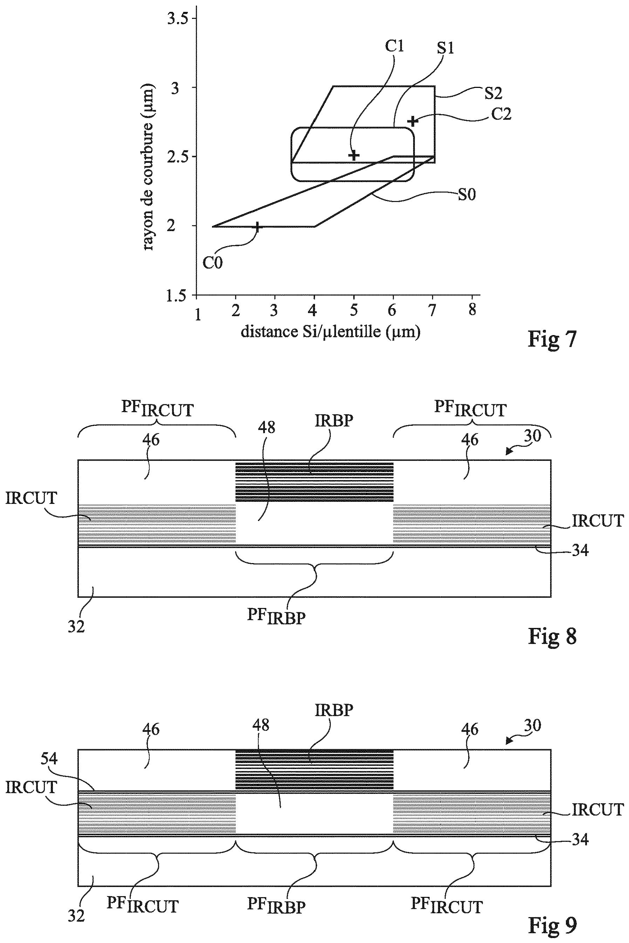

La figure 7 représente les points de fonctionnement optimaux (croix C0, C1 et C2) et les plages de valeurs optimales pour le rayon de courbure et la distance support 32-lentille 38, pour un pixel de filtre ne comprenant pas de de filtre interférentiel (surface S0), dans le cas d'un pixel de filtre PF_{IRBP} (surface S1) et dans le cas d'un pixel de filtre PF_{IRCUT} (surface S2). La figure 7 a été obtenue pour un photosite ayant, en vue de dessus, une forme carrée de 4 µm de côté avec un facteur de remplissage, qui correspond au rapport entre la surface de la région active du photosite et la surface du photosite, de 25 % pour un photosite associé au deuxième pixel de filtre PF_{IRBP} et de 55 % pour un photosite associé au premier pixel de filtre PF_{IRCUT}.

Il apparaît clairement que les plages de bon fonctionnement sont sensiblement différentes entre les configurations avec et sans filtre interférentiel.

Dans le mode de réalisation représenté sur les figures 1 et 2, une couche diélectrique du matériau d'indice de réfraction bas est présente, selon la direction d'empilement, entre le sommet du filtre interférentiel IRCUT du pixel de filtre PF_{IRCUT} et la base du filtre interférentiel IRBP du pixel de filtre PF_{IRBP}.

La figure 8 représente, de façon partielle, une variante du dispositif optoélectronique 30 dans laquelle, selon la direction d'empilement, le sommet du filtre interférentiel IRCUT du pixel de filtre PF_{IRCUT} affleure la base du filtre interférentiel IRBP du pixel de filtre PF_{IRBP}.

La figure 9 représente une autre variante du dispositif optoélectronique 30 dans laquelle, selon la direction d'empilement, une couche diélectrique 54, d'un neuvième matériau, différent des premier, deuxième, troisième et quatrième matériaux, est présente entre le sommet du filtre interférentiel IRCUT du pixel de filtre PF_{IRCUT} et la base du filtre interférentiel IRBP du pixel de filtre PF_{IRBP}. Comme cela sera décrit plus en détail par la suite, la couche 54 peut servir de couche d'arrêt de gravure lors de la formation du filtre interférentiel IRBP.

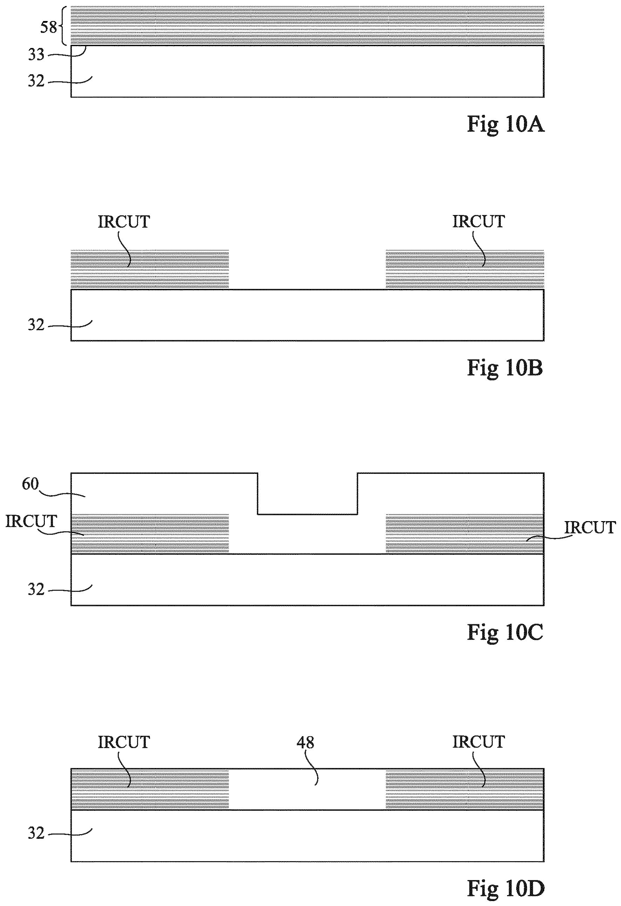

Les figures 10A à 10H sont des vues en coupe, partielles et schématiques, de structures obtenues à des étapes successives d'un mode de réalisation d'un procédé de fabrication du dispositif optoélectronique 30 représenté sur les figures 1 et 2. Sur ces figures, les couches 34 et 40 ne sont pas représentées.

La figure 10A représente la structure obtenue après le dépôt d'un premier empilement 58 de couches diélectriques ayant la structure souhaitée des filtres interférentiels IRCUT sur la totalité de la face supérieure 33 du support 32, les couches 34 et 40 n'étant pas représentées.

La figure 10B représente la structure obtenue après la gravure du premier empilement 58 au niveau des emplacements souhaités des deuxièmes pixels de filtre pour ne conserver des filtres IRCUT qu'aux emplacements des premiers pixels de filtre PF_{IRCUT}.

La figure 10C représente la structure obtenue après le dépôt d'une couche diélectrique 60, du matériau composant les blocs 48, sur les premiers filtres interférentiels IRCUT et sur le support 32 entre les premiers filtres interférentiels IRCUT. L'épaisseur de la couche diélectrique 60 est supérieure ou égale à l'épaisseur des premiers filtres interférentiels IRCUT.

La figure 10D représente la structure obtenue après une étape de planarisation, par exemple un polissage mécano-chimique (CMP, sigle anglais pour Chemical-Mechanical Planarization), qui entraîne le retrait de la couche diélectrique 60 sur les premiers filtres interférentiels IRCUT pour ne conserver que les blocs 48 des deuxièmes pixels de filtre PF_{IRBP}. Dans le présent mode de réalisation, la dernière couche au sommet des filtres interférentiels IRCUT peut jouer le rôle d'une couche d'arrêt pour l'étape de planarisation.

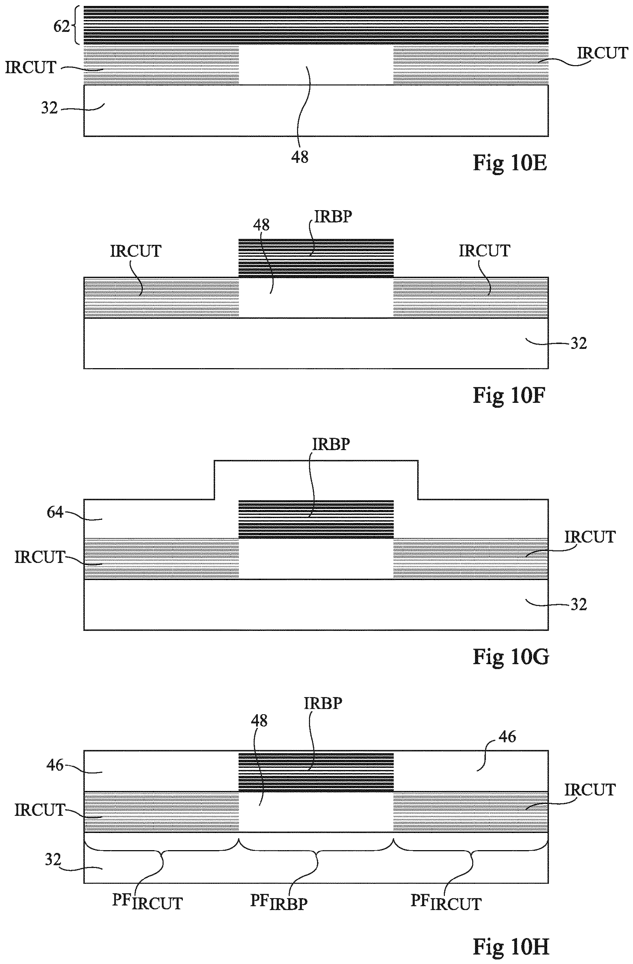

La figure 10E représente la structure obtenue après le dépôt, sur l'ensemble de la structure obtenue à l'étape précédente, d'un deuxième empilement 62 de couches diélectriques ayant la structure souhaitée des filtres interférentiels IRBP. En particulier, le deuxième empilement 62 recouvre les filtres interférentiels IRCUT et les blocs 48.

La figure 10F représente la structure obtenue après une étape de gravure des parties de l'empilement 62 recouvrant les filtres interférentiels IRCUT pour ne conserver que les filtres interférentiels IRBP reposant sur les blocs 48.

La figure 10G représente la structure obtenue après le dépôt d'une couche diélectrique 64, du matériau composant les blocs 46, sur l'ensemble de la structure obtenue à l'étape précédente, notamment sur les filtres interférentiels IRCUT et sur les filtres interférentiels IRBP. L'épaisseur de la couche diélectrique 64 est supérieure ou égale à l'épaisseur des deuxièmes filtres interférentiels IRBP.

La figure 10H représente la structure obtenue après une étape de planarisation, par exemple une CMP, qui entraîne le retrait de la couche diélectrique 64 sur les filtres interférentiels IRBP pour ne conserver que les blocs 46 des premiers pixels de filtre PF_{IRCUT}. Dans le présent mode de réalisation, la dernière couche au sommet des filtres interférentiels IRBP peut jouer le rôle d'une couche d'arrêt pour l'étape de planarisation.

Le mode de réalisation de procédé de fabrication décrit précédemment est notamment adapté au cas où la face supérieure 33 du support 32 est sensiblement plane. Toutefois, la face supérieure 33 du support 32 peut comprendre des zones en relief. C'est notamment le cas lorsque le support 32 correspond à la face arrière d'un circuit électronique fabriqué selon une technologie CMOS. Les zones en relief peuvent notamment correspondre au pourtour de plots de contact et avoir une dimension transversale de l'ordre de quelques micromètres.

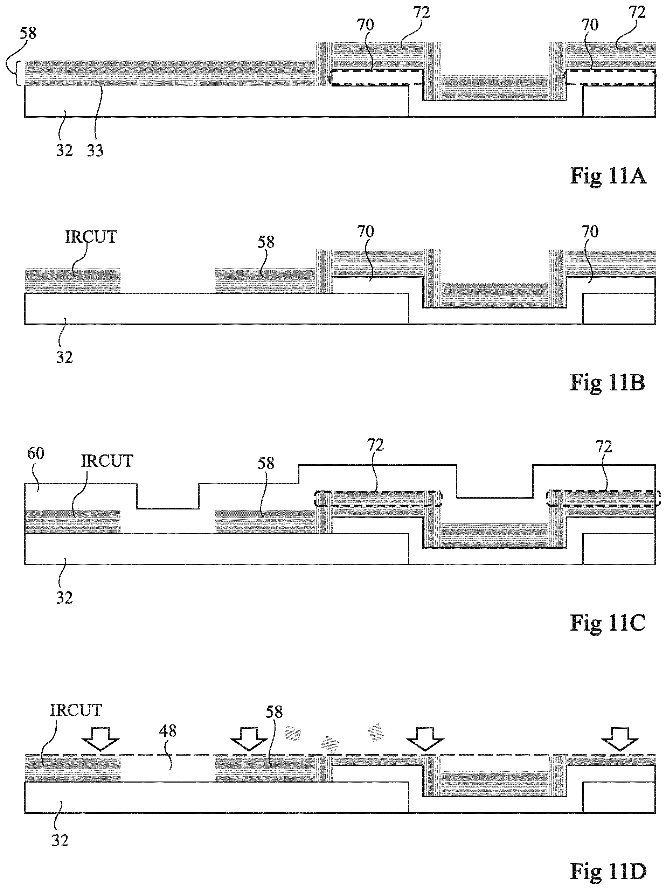

Les figures 11A à 11D sont des vues en coupe, partielles et schématiques, de structures obtenues à des étapes successives d'un procédé de fabrication du dispositif optoélectronique 30 représenté sur les figures 1 et 2 dans le cas où le support 32 présente des zones en relief.

La figure 11A représente la structure obtenue après une étape similaire à celle décrite précédemment en relation avec la figure 10A et comprenant le dépôt du premier empilement 58 sur la surface supérieure 33 du support 32. On note que, dans le présent mode de réalisation, le support 32 comprend des zones en relief 70 par rapport au plan de base de la surface 33. A titre d'exemple les zones en relief 70 peuvent avoir une épaisseur de l'ordre de 1 µm par rapport au plan de base de la surface 33. Les zones en relief 70 ne sont pas destinées à être recouvertes par des pixels de filtre. Toutefois, l'empilement 58 recouvre les zones en relief 70, ce qui se traduit par des zones en relief 72 sur les parties de l'empilement 58 recouvrant les zones en relief 70.

La figure 11B représente la structure obtenue après une étape similaire à celle décrite précédemment en relation avec la figure 10B comprenant la gravure de l'empilement 58 notamment pour former les premiers filtres interférentiels IRCUT.

La figure 11C représente la structure obtenue après une étape similaire à celle décrite précédemment en relation avec la figure 10C et comprenant le dépôt de la couche diélectrique 60 sur l'ensemble de la structure formée à l'étape précédente et notamment sur les zones en relief 72.

La figure 11D représente la structure obtenue après une étape de planarisation similaire à celle décrite précédemment en relation avec la figure 10D. Dans le présent mode de réalisation, l'étape de planarisation est poursuivie jusqu'à atteindre le sommet de l'empilement 58 en dehors des zones en relief 72. Ceci entraîne la gravure des zones en relief 72. Un inconvénient est que les zones en relief 72 comprennent des espaceurs latéraux verticaux ou inclinés ayant une structure multicouche. Lorsque la planarisation, notamment par CMP, atteint ces espaceurs, on peut avoir des arrachements de gros morceaux qui vont se disperser sur toute la structure et rendre la structure inutilisable.

Il est alors possible que le procédé ne puisse pas être poursuivi en raison des défauts générés dans l'étape de planarisation sur les espaceurs à structures multicouches inclinées.

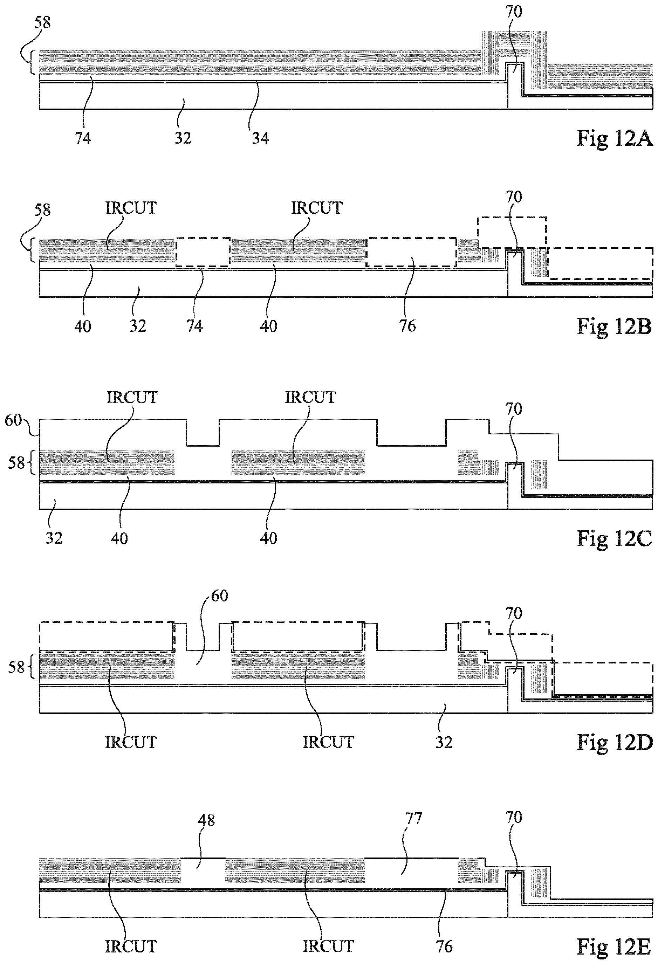

Les figures 12A à 12K représentent les structures obtenues à des étapes successives d'une variante du mode de réalisation du procédé décrit précédemment en relation avec les figures 10A à 10H pour la fabrication du dispositif électronique représenté sur les figures 1 et 2, cette variante étant adaptée au cas où le support 32 comprend des zones de relief dont la hauteur par rapport au plan de base du support 32 est inférieure à l'épaisseur des premiers filtres interférentiels IRCUT.

La figure 12A représente la structure obtenue après une étape similaire à l'étape décrite précédemment en relation avec la figure 11A à la différence qu'une couche diélectrique 74 est interposée entre l'empilement 58 et le support 32. La couche isolante 74 a la même épaisseur et la même composition que la couche 40.

La figure 12B représente la structure obtenue après une étape similaire à l'étape décrite précédemment en relation avec la figure 11B et comprenant la gravure de l'empilement 58 et d'une partie de la couche diélectrique 74, à la fois aux emplacements souhaités des deuxièmes pixels de filtre PF_{IRBP}, et sur les zones en relief 70. Ceci permet de délimiter les filtres interférentiels IRCUT et les couches 40 pour chaque pixel de filtre PF_{IRCUT}. La couche diélectrique 74 permet de réaliser une surgravure tout en évitant une attaque indésirable de la couche anti-reflet 34 lors du retrait de l'empilement 58. En figure 12B, une gravure de l'empilement 58 est en outre réalisée dans une zone 76 qui peut être utilisée à une étape ultérieure pour réaliser des opérations de vérification métrologique.

La figure 12C représente la structure obtenue après une étape analogue à l'étape décrite précédemment en relation avec la figure 10C. L'épaisseur de la couche diélectrique 60 est supérieure à l'épaisseur de l'empilement 58, par exemple de l'ordre de 1,5 fois l'épaisseur de l'empilement 58, par exemple de l'ordre de 3 µm.

La figure 12D représente la structure obtenue après une étape de gravure au moins partielle des parties de la couche 60 recouvrant les filtres interférentiels IRCUT et recouvrant les zones en relief 70. Cette étape peut comprendre une étape de photolithographie utilisant le masque complémentaire du masque celui utilisé pour la gravure de l'empilement 58 à l'étape décrite précédemment en relation avec la figure 12B. Cette étape de gravure de la couche 60 peut ne pas être présente.

La figure 12E représente la structure obtenue après une étape de planarisation, par exemple par CMP, analogue à l'étape décrite précédemment en relation avec la figure 10D. De préférence, la dernière couche déposée de l'empilement 58 correspond à une couche d'arrêt de l'étape de planarisation. Lorsque l'étape décrite précédemment en relation avec la figure 12D est présente, elle permet de faciliter l'étape de planarisation par CMP. L'étape de planarisation permet notamment de délimiter les blocs diélectriques 48 et un bloc isolant 77 à l'emplacement 76. Cette étape permet notamment de bien maîtriser l'épaisseur du bloc 48 qui est par ce procédé sensiblement égale à celle du filtre interférentiel IRCUT à ce stade du procédé. La maîtrise de l'épaisseur du bloc 48 est importante pour une bonne qualité de la réponse spectrale du pixel de filtre PF_{IRBP}.

Il peut être avantageux que l'arrêt de l'étape de planarisation de la couche 60 soit réalisé sur une couche d'arrêt plutôt qu'à l'achèvement d'une durée déterminée. En effet, il peut être difficile, avec un arrêt de l'étape de planarisation à l'achèvement d'une durée déterminée, de maîtriser l'épaisseur restante de la couche diélectrique 60 avec autant de précision que lors d'un arrêt de l'étape de planarisation sur une couche d'arrêt. De plus, cela signifie que l'arrêt de l'étape de planarisation peut ne pas être uniforme sur la totalité de la surface de la structure. Il peut, en particulier, y avoir une dispersion des épaisseurs de la partie restante de la couche diélectrique 60 trop importante par rapport aux contraintes dimensionnelles pour le bon fonctionnement des pixels de filtre. En outre, il peut être difficile de reproduire exactement les mêmes conditions d'arrêt d'un dispositif optoélectronique à l'autre.

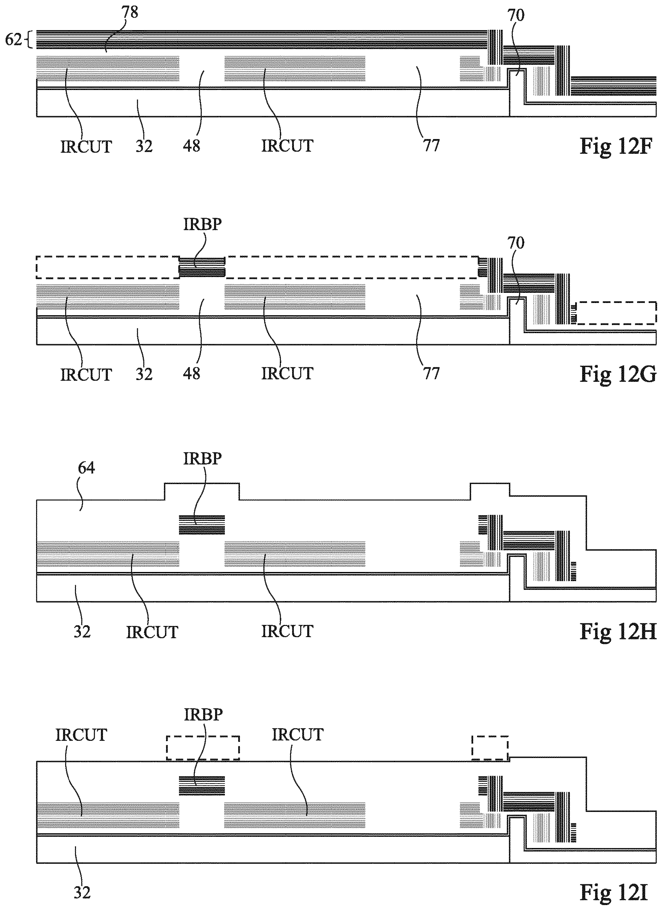

La figure 12F représente la structure obtenue après une étape analogue à l'étape décrite précédemment en relation avec la figure 10E à la différence que l'étape de dépôt de l'empilement 62 est précédée d'une étape de dépôt d'une couche diélectrique 78 sur l'ensemble de la structure obtenue à l'étape précédente, du même matériau que la couche 60 ou d'indice de réfraction voisin. L'épaisseur de la couche 78 est bien contrôlée car elle résulte d'un dépôt. De ce fait, dans le présent mode de réalisation, l'épaisseur du bloc diélectrique 48 est supérieure à l'épaisseur du filtre interférentiel IRCUT et choisie pour optimiser la transmission du second filtre interférentiel IRBP déposé sur le bloc 48.

La figure 12G représente la structure obtenue après une étape analogue à l'étape décrite précédemment en relation avec la figure 10F comprenant la gravure des parties de l'empilement 62 et de tout ou partie de la couche diélectrique 78 recouvrant les filtres interférentiels IRCUT et, en outre, recouvrant les zones de relief 72 et le bloc diélectrique 77. De préférence, la dernière couche déposée de l'empilement 58 correspond à une couche d'arrêt de gravure pour l'étape de gravure de la couche diélectrique 78. Cette étape entraîne la délimitation des filtres interférentiels IRBP.

La figure 12H représente la structure obtenue après une étape analogue à l'étape décrite précédemment en relation avec la figure 10G. L'épaisseur de la couche 64 peut être de l'ordre de 1,5 µm à 2,5 µm. Cette épaisseur n'est pas critique pour les performances du dispositif optoélectronique 30 à condition que l'écart d'indice avec les matériaux des filtres colorés déposés ultérieurement et le matériau composant les lentilles déposées ultérieurement soient faibles, de préférence inférieur à 0,2.

La figure 12I représente la structure obtenue après une étape de gravure au moins partielle des parties de la couche 64 recouvrant les filtres interférentiels IRBP et recouvrant les zones en relief 70. Cette étape peut comprendre une étape de photolithographie utilisant le masque complémentaire du masque utilisé pour la gravure de l'empilement 62 à l'étape décrite précédemment en relation avec la figure 12G. Cette étape de gravure de la couche 64 peut ne pas être présente.

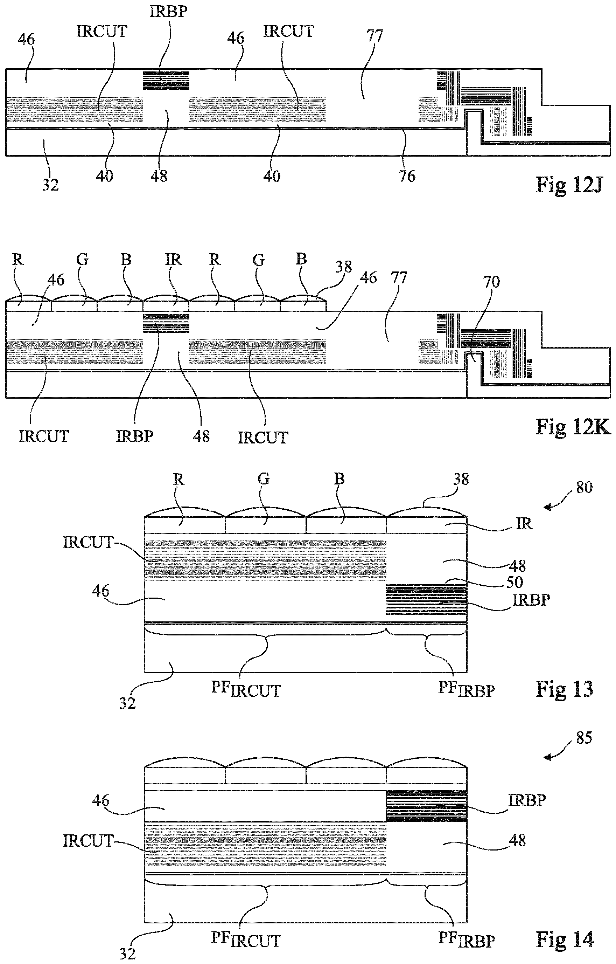

La figure 12J représente la structure obtenue après une étape de planarisation, par exemple par CMP, analogue à l'étape décrite précédemment en relation avec la figure 10H. Selon un mode de réalisation, l'arrêt de l'étape de planarisation peut être réalisé à l'achèvement d'une durée déterminée avant d'atteindre les filtres interférentiels IRBP. Selon un autre mode de réalisation, la dernière couche déposée de l'empilement 62 correspond à une couche d'arrêt de l'étape de planarisation. Lorsque l'étape décrite précédemment en relation avec la figure 12I est présente, elle permet de faciliter l'étape de planarisation par CMP. L'étape de planarisation permet notamment de délimiter les blocs diélectriques 46 et le bloc diélectrique 77 à l'emplacement 76 et de faciliter l'étalement des résines lors de la formation des filtres colorées R, G, B, IR.

La figure 12K représente la structure obtenue après la formation des filtres colorés R, G, B, IR et des lentilles 38.

La figure 13 est une vue en coupe, partielle et schématique, d'un autre mode de réalisation d'un dispositif optoélectronique 80 comprenant l'ensemble des éléments du dispositif optoélectronique 30 représenté sur les figures 1 et 2 à la différence que les positions relatives entre les blocs 46, 48 et les filtres interférentiels IRCUT, IRBP, selon la direction d'empilement des couches sur le support 32, sont inversées par rapport au dispositif optoélectronique 30. A titre d'exemple, pour chaque premier pixel de filtre PF_{IRCUT}, le bloc diélectrique 46 est interposé entre le support 32 et le filtre interférentiel IRCUT et, pour chaque deuxième pixel de filtre PF_{IRBP}, le filtre interférentiel IRBP est interposé entre le support 32 et le bloc diélectrique 48. Le filtre interférentiel IRCUT est donc formé sur le bloc diélectrique 46 dont l'épaisseur est supérieure ou égale à celle du filtre interférentiel IRBP alors que filtre interférentiel IRBP est formé directement sur le support 32 ou sur une couche diélectrique mince. Ceci peut être avantageux dans la mesure où le pixel de filtre PF_{IRBP} peut être plus sensible, d'un point de vue des performances optiques, aux dispersions géométriques et d'indices de réfraction que le pixel de filtre PF_{IRCUT}. De ce fait, l'impact, dans le dispositif optoélectronique 80, de la dispersion d'épaisseur du bloc diélectrique 46 sous le filtre interférentiel IRCUT sur la réponse optique du pixel de filtre PF_{IRCUT} est donc inférieur à l'impact, dans le dispositif optoélectronique 30, de la dispersion d'épaisseur du bloc diélectrique 48 sous le filtre interférentiel IRBP sur la réponse optique du pixel de filtre PF_{IRBP}. Toutefois, dans le présent mode de réalisation, il peut être nécessaire de prévoir une couche d'arrêt de gravure spécifique au sommet du filtre interférentiel IRBP dans la mesure où la couche 50 du troisième matériau diélectrique ayant un indice de réfraction haut n_{H2} au sommet du filtre interférentiel IRBP peut ne pas pouvoir servir de couche d'arrêt de gravure pour le matériau d'indice de réfraction bas n_{B1} du filtre interférentiel IRCUT.

La figure 14 est une vue en coupe, partielle et schématique, d'un autre mode de réalisation d'un dispositif optoélectronique 85 dans lequel le bloc diélectrique 46 pour chaque premier pixel de filtre PF_{IRCUT} est composé d'une résine autoplanarisante. Ceci permet, de façon avantageuse, de simplifier le procédé de fabrication du dispositif optoélectronique 85 par rapport au dispositif optoélectronique 30. En effet, les étapes décrites précédemment en relation avec les figures 12H à 12J peuvent être remplacées par une unique étape de dépôt de la résine autoplanarisante. Selon un mode de réalisation, la résine autoplanarisante est en un matériau sensiblement transparent à la lumière visible et au rayonnement infrarouge. Selon un autre mode de réalisation, la résine autoplanarisante est en un matériau sensiblement transparent à la lumière visible et sensiblement opaque au rayonnement infrarouge.

Dans les modes de réalisation décrits précédemment, le filtre coloré IR recouvrant le deuxième pixel de filtre PF_{IRBP} est en résine noire. Ce filtre coloré permet avantageusement de bloquer les rayonnements à des longueurs d'onde inférieures à environ 800 nm et facilite la conception du filtre interférentiel IRBP. Toutefois, selon un autre mode de réalisation, le filtre IR peut être remplacé par une résine au moins partiellement transparente à la lumière visible.

Dans les modes de réalisation décrits précédemment, les lentilles 38 ont des structures identiques pour tous les filtres colorés R, G, B, IR.

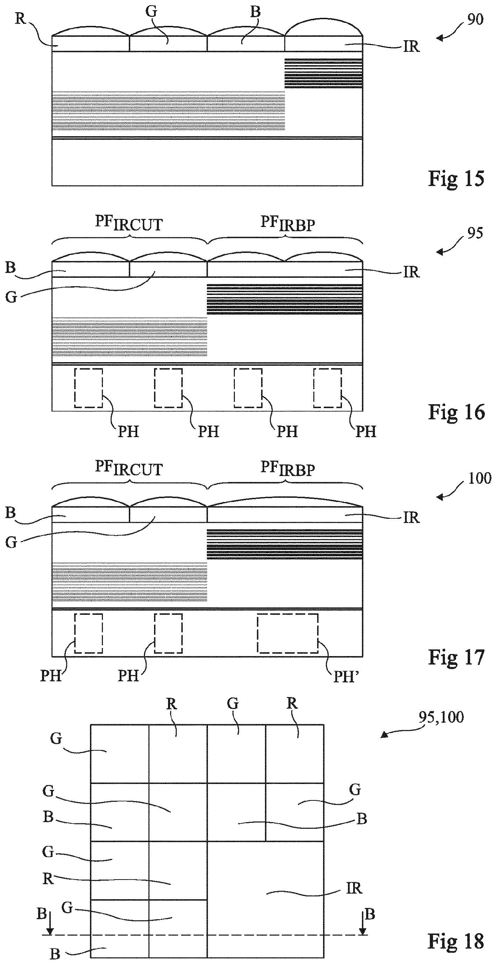

La figure 15 est une vue en coupe, partielle et schématique, d'un autre mode de réalisation d'un dispositif optoélectronique 90 dans lequel les lentilles 38 sont de formes différentes selon les filtres colorés R, G, B, IR. A titre d'exemple, en figure 15, on a représenté la lentille associée au filtre coloré IR plus épaisse que les lentilles associées aux autres filtres colorés R, G et B. Ceci permet notamment de s'adapter à des photodiodes ayant des caractéristiques différentes (par exemple une taille du pixel IR plus grande ou un facteur de remplissage différent des photodiodes visible) et/ou de s'adapter aux réponses spectrales de l'ensemble comprenant le pixel de filtre et la lentille.

Les photodiodes recouvertes par les pixels de filtre PF_{IRCUT} et PF_{IRBP} peuvent avoir les mêmes dimensions ou avoir des dimensions différentes. Le premier pixel de filtre PF_{IRCUT} recouvre de préférence autant de photodiodes qu'il y a de types différents de filtres colorés R, G et B laissant passer la lumière visible. Le deuxième pixel de filtre peut recouvrir une seule photodiode ou au moins deux photodiodes.

Les figures 16 et 17 sont des vues en coupe, partielles et schématiques, d'autres modes de réalisation de dispositifs optoélectroniques 95, 100. La figure 18 est vue de dessus du dispositif optoélectronique 95, 100 représenté sur la figure 16 ou 18. Les figures 16 et 17 sont des vues en coupe de la figure 18 selon la ligne B-B. Pour le dispositif optoélectronique 95 représenté en figure 16, chaque deuxième pixel de filtre PF_{IRBP} recouvre deux photodiodes PH. Pour le dispositif optoélectronique 100 représenté en figure 17, chaque deuxième pixel de filtre PF_{IRBP} recouvre une photodiode PH' de plus grandes dimensions que les photodiodes PH associées aux premiers pixels de filtre PF_{IRCUT}.

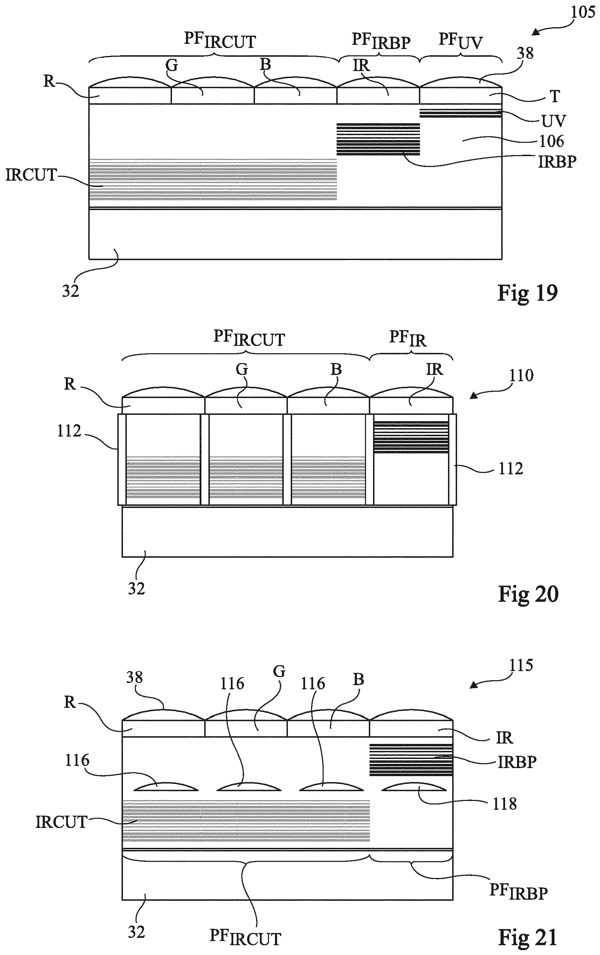

La figure 19 est une vue en coupe d'un autre mode de réalisation d'un dispositif optoélectronique 105 dans lequel le dispositif optoélectronique 105 comprend l'ensemble des éléments du dispositif optoélectronique 30 représenté sur les figures 1 et 2 et comprend, en outre, un troisième pixel de filtre PF_{UV}, par exemple adapté à filtrer le rayonnement ultraviolet, recouvert d'un filtre T et d'une lentille 38. Dans ce cas, le troisième pixel de filtre peut comprendre, sur le support 32, un bloc isolant 106 d'un matériau diélectrique et un filtre interférentiel UV, comprenant par exemple une alternance de couches métalliques et de couches diélectriques, par exemple une alternance de couches d'argent ou d'aluminium et de couches diélectriques. Le filtre coloré T recouvrant le troisième pixel de filtre PF_{UV} peut être en résine transparente.

La figure 20 est une vue en coupe d'un autre mode de réalisation d'un dispositif optoélectronique 110 dans lequel le dispositif optoélectronique 110 comprend l'ensemble des éléments du dispositif optoélectronique 30 représenté sur les figures 1 et 2 et comprend, en outre, des murs réfléchissants 112 qui s'étendent sur toute l'épaisseur des pixels de filtre PF_{IRCUT} et PF_{IRBP} et qui séparent les deuxièmes pixels de filtre PF_{IRBP} des premiers pixels de filtre PF_{IRCUT} et qui, en outre, pour chaque premier pixel de filtre PF_{IRCUT}, délimitent une portion du premier pixel de filtre PF_{IRCUT} en vis-à-vis de chaque filtre coloré R, G, B. Les murs 112 réfléchissent la lumière visible et le rayonnement infrarouge, notamment le rayonnement proche infrarouge. Les murs 112 peuvent être métalliques ou comprendre un revêtement métallique d'épaisseur typiquement supérieure à 50 nm. Ceci permet, de façon avantageuse, de réduire la diaphonie optique du dispositif optoélectronique 110. Les murs 112 peuvent être réalisés après les étapes de formation des pixels de filtre PF_{IRCUT} et PF_{IRBP}.

La figure 21 est une vue en coupe d'un autre mode de réalisation d'un dispositif optoélectronique 115 dans lequel le dispositif optoélectronique 115 comprend l'ensemble des éléments du dispositif optoélectronique 30 représenté sur les figures 1 et 2 et comprend, en outre, pour chaque premier pixel de filtre PF_{IRCUT}, des lentilles 116 recouvrant le filtre interférentiel IRCUT du premier pixel de filtre PF_{IRCUT}, chaque lentille 116 étant interposée entre le filtre interférentiel IRCUT et l'un des filtres colorés R, G et B. Le dispositif optoélectronique 115 comprend, en outre, pour chaque deuxième pixel de filtre PF_{IRBP}, une lentille 118 recouverte par le filtre interférentiel IRBP du deuxième pixel de filtre PF_{IRBP}, chaque lentille 118 étant interposée entre le filtre interférentiel IRBP et le support 32. Ceci permet de diminuer la diaphonie optique du dispositif optoélectronique 115. Ces lentilles 116, 118 sont par exemple en nitrure de silicium pour assurer un contraste d'indice de réfraction suffisant avec le milieu avoisinant, par exemple un oxyde, de préférence un écart supérieur à 0,5. Une étape de planarisation de la couche d'oxyde déposée au-dessus des lentilles 116, 118 en nitrure de silicium est de préférence réalisée avant la réalisation des filtres interférentiels IRBP.

Des modes de réalisation particuliers ont été décrits. Diverses variantes et modifications apparaîtront à l'homme de l'art. En particulier, bien que, dans les modes de réalisation décrits précédemment, chaque lentille 38 soit représentée centrée par rapport à la photodiode PH associée, il est clair que pour certaines applications, on peut décentrer chaque lentille par rapport à la photodiode associée. En outre, dans les modes de réalisation décrits précédemment, les procédés de fabrication peuvent être modifiés pour faire en sorte que les filtres interférentiels IRCUT des premiers filtres de pixel PF_{IRCUT} varient en fonction de la position du filtre de pixel PF_{IRCUT} dans le dispositif optoélectronique.

Divers modes de réalisation avec diverses variantes ont été décrits ci-dessus. On note que l'homme de l'art peut combiner divers éléments de ces divers modes de réalisation et variantes sans faire preuve d'activité inventive. En particulier, au moins deux des modes de réalisation de dispositifs optoélectroniques 80, 85, 90, 95, 100, 105, 110, 115 peuvent être combinés ensemble.

## Revendications

1. Filtre interférentiel pixélisé (36) destiné à reposer sur un support (32) et comprenant, selon une direction d'empilement :
des premiers pixels de filtre (PF_{IRCUT}) de mêmes épaisseurs, comprenant chacun un premier filtre interférentiel (IRCUT) recouvert d'un premier bloc diélectrique (46) ; et
des deuxièmes pixels de filtre (PF_{IRBP}) de mêmes épaisseurs, comprenant chacun un deuxième bloc diélectrique (48), dont l'épaisseur est supérieure ou égale à l'épaisseur du premier filtre interférentiel, recouvert d'un deuxième filtre interférentiel (IRBP), dont l'épaisseur est inférieure ou égale à l'épaisseur du premier bloc diélectrique,
dans lequel, pour au moins l'un des deuxièmes pixels de filtre, le deuxième bloc diélectrique du deuxième pixel de filtre est interposé entre les premiers filtres interférentiels de deux premiers pixels de filtre et le deuxième filtre interférentiel du deuxième pixel de filtre est interposé entre les premiers blocs diélectriques des deux premiers pixels de filtre,
le filtre interférentiel pixélisé comprenant, entre chaque paire de premier et deuxième pixels de filtre adjacents, une zone de transition dont la dimension minimale entre le premier pixel de filtre et le deuxième pixel de filtre de ladite paire, perpendiculairement à la direction d'empilement, est inférieure à 500 nm,
et dans lequel le filtre interférentiel pixélisé comprend des première et deuxième faces opposées, la première face étant destinée à être au contact du support et la deuxième face étant sensiblement plane.

2. Filtre interférentiel pixélisé selon la revendication 1, dans lequel chaque premier filtre interférentiel (IRCUT) comprend une alternance de premières couches diélectriques (42) d'un premier matériau diélectrique ayant un premier indice de réfraction dans le domaine visible et de deuxièmes couches diélectriques (44) d'un deuxième matériau diélectrique ayant un deuxième indice de réfraction dans le domaine visible strictement inférieur au premier indice de réfraction et dans lequel chaque deuxième filtre interférentiel (IRBP) comprend une alternance de troisièmes couches diélectriques (50) d'un troisième matériau diélectrique ayant un troisième indice de réfraction dans le domaine infrarouge et de quatrièmes couches diélectriques (52) d'un quatrième matériau diélectrique ayant un quatrième indice de réfraction dans le domaine infrarouge strictement inférieur au troisième indice de réfraction ; ou
dans lequel chaque premier filtre interférentiel (IRCUT) comprend une alternance des troisièmes couches diélectriques et des quatrièmes couches diélectriques et dans lequel chaque deuxième filtre interférentiel (IRBP) comprend une alternance des premières couches diélectriques et des quatrièmes couches diélectriques.

3. Filtre interférentiel pixélisé selon la revendication 2, dans lequel le premier matériau diélectrique peut être choisi dans le groupe comprenant le nitrure de silicium (SiN), l'oxyde d'hafnium (HfOₓ), l'oxyde d'aluminium (AlOₓ), un alliage d'aluminium, d'oxygène et d'azote (AlOₓN_{y}), un alliage de silicium, d'oxygène, de carbone et d'azote (SiOₓC_{y}N_{z}), le nitrure de silicium (SiNₓ), l'oxyde de niobium (NbOₓ), l'oxyde de tantale (TaOₓ), l'oxyde de titane (TiOₓ) et les mélanges d'au moins deux de ces composés.

4. Filtre interférentiel pixélisé selon la revendication 2 ou 3, dans lequel le deuxième matériau diélectrique et/ou le quatrième matériau diélectrique peuvent être chacun choisis dans le groupe comprenant le dioxyde de silicium (SiO₂), le fluorure de magnésium (MgF₂), l'oxyde de silicium (SiOₓ), l'oxynitrure de silicium (SiOₓN_{y}), l'oxyde d'hafnium (HfOₓ), l'oxyde d'aluminium (AlOₓ), un film à base d'aluminium, d'oxygène et d'azote (AlOₓN_{y}), un film à base de silicium, d'oxygène, de carbone et d'azote (SiOₓC_{y}N_{z}), le nitrure de silicium (SiNₓ) et les mélanges d'au moins deux de ces composés.

5. Filtre interférentiel pixélisé selon l'une quelconque des revendications 2 à 4, dans lequel le troisième matériau diélectrique peut être choisi dans le groupe comprenant le silicium amorphe (aSi), le silicium amorphe hydrogéné (aSiH) et les mélanges de ces composés.

6. Capteur d'images (30 ; 80 ; 85 ; 90 ; 95 ; 100 ; 105 ; 110 ; 115) comprenant un support (32) et le filtre interférentiel pixélisé (36) selon l'une quelconque des revendications 1 à 5 reposant sur le support.

7. Capteur d'images selon la revendication 6, comprenant, en outre, une couche antireflet (34) entre le support (32) et le filtre interférentiel pixélisé (36).

8. Capteur d'images selon la revendication 6 ou 7, comprenant, pour chaque premier pixel de filtre (PF_{IRCUT}) et recouvrant ledit premier pixel de filtre, au moins un filtre coloré (R) adapté à laisser passer la lumière visible seulement dans une première plage de longueurs d'onde et un filtre coloré (G) adapté à laisser passer la lumière visible seulement dans une deuxième plage de longueurs d'onde différentes de la première plage.

9. Capteur d'images selon la revendication 8, comprenant, pour chaque filtre coloré (R) de chaque premier pixel de filtre (PF_{IRCUT}) , une première lentille (38) recouvrant ledit filtre coloré, et comprenant, pour chaque deuxième pixel de filtre (PF_{IRBP}), une deuxième lentille recouvrant le deuxième pixel de filtre.

10. Procédé de fabrication d'un filtre interférentiel pixélisé (36) selon l'une quelconque des revendications 1 à 5, comprenant les étapes successives suivantes :
a) dépôt, sur un substrat (32), d'un premier empilement (58) de couches diélectriques ayant la structure des premiers filtres interférentiels (IRCUT) ;
b) gravure du premier empilement pour retirer le premier empilement aux emplacements des deuxièmes pixels de filtres (PF_{IRBP}) et conserver les premiers filtres interférentiels aux emplacements des premiers pixels de filtre (PF_{IRCUT}) ;
c) dépôt d'une première couche isolante (60), ayant une épaisseur supérieure à l'épaisseur du premier empilement, sur les premiers filtres interférentiels et entre les premiers filtres interférentiels ;
d) gravure d'au moins une partie de la première couche isolante sur les premiers filtres interférentiels ;
e) dépôt d'un deuxième empilement (62) de couches diélectriques ayant la structure des deuxièmes filtres interférentiels (IRBP) ;
f) gravure du deuxième empilement pour retirer le deuxième empilement aux emplacements des premiers pixels de filtres et conserver les deuxièmes filtres interférentiels aux emplacements des deuxièmes pixels de filtre ;
g) dépôt d'une deuxième couche isolante (64), ayant une épaisseur supérieure à l'épaisseur du deuxième empilement, sur les deuxièmes filtres interférentiels et entre les deuxièmes filtres interférentiels ; et
h) gravure d'au moins une partie de la deuxième couche isolante sur les deuxièmes filtres interférentiels.

11. Procédé selon la revendication 10, dans lequel, à l'étape a), le premier empilement (58) est déposé sur un support (32) comprenant au moins une zone en relief (70), le procédé comprenant, à l'étape b), la gravure de la partie du premier empilement recouvrant la zone en relief.

12. Procédé selon la revendication 10 ou 11, dans lequel la gravure de la première couche isolante (60) et/ou de la deuxième couche isolante (64) comprend une étape de polissage mécano-chimique.

## Patentansprüche

1. Ein gepixeltes Interferenzfilter (36), das dazu bestimmt ist, auf einem Träger (32) aufzuliegen, und das in einer Stapelrichtung Folgendes aufweist:
erste Filterpixel (PF_{IRCUT}) mit gleichen Dicken, die jeweils ein erstes Interferenzfilter (IRCUT) aufweisen, das mit einem ersten dielektrischen Block (46) bedeckt ist; und
zweite Filterpixel (PF_{IRBP}) mit gleichen Dicken, die jeweils einen zweiten dielektrischen Block (48) aufweisen, der eine Dicke aufweist, die größer oder gleich der Dicke des ersten Interferenzfilters ist, und der mit einem zweiten Interferenzfilter (IRBP) bedeckt ist, das eine Dicke aufweist, die kleiner oder gleich der Dicke des ersten dielektrischen Blocks ist,
wobei für mindestens eines der zweiten Filterpixel der zweite dielektrische Block des zweiten Filterpixels zwischen den ersten Interferenzfiltern von zwei ersten Filterpixeln und das zweite Interferenzfilter des zweiten Filterpixels zwischen den ersten dielektrischen Blöcken der ersten beiden Filterpixel angeordnet ist,
wobei das gepixelte Interferenzfilter zwischen jedem Paar von ersten und zweiten benachbarten Filterpixeln einen Übergangsbereich mit einer minimalen Abmessung zwischen dem ersten Filterpixel und dem zweiten Filterpixel des Paares, senkrecht zur Stapelrichtung, kleiner als 500 nm aufweist,
und wobei das gepixelte Interferenzfilter eine erste und eine zweite gegenüberliegende Oberfläche aufweist, wobei die erste Oberfläche dazu bestimmt ist, mit dem Träger in Kontakt zu sein, und die zweite Oberfläche im Wesentlichen planar ist.

2. Gepixeltes Interferenzfilter nach Anspruch 1, wobei jedes erste Interferenzfilter (IRCUT) eine Abwechslung von ersten dielektrischen Schichten (42) aus einem ersten dielektrischen Material mit einem ersten Brechungsindex im sichtbaren Bereich und von zweiten dielektrischen Schichten (44) aus einem zweiten dielektrischen Material mit einem zweiten Brechungsindex im sichtbaren Bereich, der kleiner als der erste Brechungsindex ist, aufweist und wobei jedes zweite Interferenzfilter (IRBP) eine Abwechslung von dritten dielektrischen Schichten (50) aus einem dritten dielektrischen Material mit einem dritten Brechungsindex im Infrarotbereich und von vierten dielektrischen Schichten (52) aus einem vierten dielektrischen Material mit einem vierten Brechungsindex im Infrarotbereich, der kleiner als der dritte Brechungsindex ist, aufweist; oder
wobei jedes erste Interferenzfilter (IRCUT) eine Abwechslung der dritten dielektrischen Schichten und der vierten dielektrischen Schichten aufweist und wobei jedes zweite Interferenzfilter (IRBP) eine Abwechslung der ersten dielektrischen Schichten und der vierten dielektrischen Schichten umfasst.

3. Gepixeltes Interferenzfilter nach Anspruch 2, wobei das erste dielektrische Material aus der Gruppe ausgewählt werden kann, die Siliziumnitrid (SiN), Hafniumoxid (HfOₓ), Aluminiumoxid (AlOₓ), eine Legierung aus Aluminium, Sauerstoff und Stickstoff (AlOₓN_{y}), eine Legierung aus Silizium, Sauerstoff, Kohlenstoff und Stickstoff (SiOₓC_{y}N_{z}), Siliziumnitrid (SiNₓ), Nioboxid (NbOₓ), Tantaloxid (TaOₓ), Titanoxid (TiOₓ) und Mischungen aus mindestens zwei dieser Verbindungen aufweist.

4. Gepixeltes Interferenzfilter nach Anspruch 2 oder 3, wobei das zweite dielektrische Material und/oder das vierte dielektrische Material jeweils aus der Gruppe ausgewählt werden können, die Siliziumdioxid (SiO₂), Magnesiumfluorid (MgF₂), Siliziumoxid (SiOx), Siliziumoxynitrid (SiOₓN_{y}), Hafniumoxid (HfOₓ), Aluminiumoxid (AlOₓ), eine Schicht aus Aluminium, Sauerstoff und Stickstoff (AlOₓN_{y}), eine Schicht aus Silizium, Sauerstoff, Kohlenstoff und Stickstoff (SiOₓC_{y}N_{z}), Siliziumnitrid (SiNₓ) und Mischungen aus mindestens zwei dieser Verbindungen aufweist.

5. Gepixeltes Interferenzfilter nach einem der Ansprüche 2 bis 4, wobei das dritte dielektrische Material aus der Gruppe ausgewählt werden kann, die amorphes Silizium (aSi), hydriertes amorphes Silizium (aSiH) und Mischungen dieser Verbindungen aufweist.

6. Ein Bildsensor (30; 80; 85; 90; 95; 100; 105; 110; 115) mit einem Träger (32) und dem gepixelten Interferenzfilter (36) nach einem der Ansprüche 1 bis 5, der auf dem Träger ruht.

7. Bildsensor nach Anspruch 6, ferner mit einer Antireflexionsschicht (34) zwischen dem Träger (32) und dem gepixelten Interferenzfilter (36).

8. Bildsensor nach Anspruch 6 oder 7, der für jedes erste Filterpixel (PF_{IRCUT}), das das erste Filterpixel bedeckt, mindestens ein Farbfilter (R), das sichtbares Licht nur in einem ersten Wellenlängenbereich durchlassen kann, und ein Farbfilter (G), das sichtbares Licht nur in einem zweiten, vom ersten Bereich verschiedenen Wellenlängenbereich durchlassen kann, aufweist.

9. Bildsensor nach Anspruch 8, der für jedes Farbfilter (R) jedes ersten Filterpixels (PF_{IRCUT}) eine erste Linse (38) aufweist, die das Farbfilter abdeckt, und der für jedes zweite Filterpixel (PF_{IRBP}) eine zweite Linse umfasst, die das zweite Filterpixel abdeckt.

10. Ein Verfahren zur Herstellung des gepixelten Interferenzfilters (36) nach einem der Ansprüche 1 bis 5, das die folgenden aufeinanderfolgenden Schritte aufweist:
a) Aufbringen eines ersten Stapels (58) dielektrischer Schichten mit der Struktur der ersten Interferenzfilter (IRCUT) auf ein Substrat (32);
b) Ätzen des ersten Stapels, um den ersten Stapel von den Stellen der zweiten Filterpixel (PF_{IRBP}) zu entfernen und die ersten Interferenzfilter an den Stellen der ersten Filterpixel (PF_{IRCUT}) zu halten;
c) Aufbringen einer ersten Isolierschicht (60) mit einer Dicke, die größer ist als die Dicke des ersten Stapels, auf den ersten Interferenzfiltern und zwischen den ersten Interferenzfiltern;
d) Ätzen mindestens eines Teils der ersten Isolierschicht auf den ersten Interferenzfiltern;
e) Aufbringen eines zweiten Stapels (62) dielektrischer Schichten mit der Struktur der zweiten Interferenzfilter (IRBP);
f) Ätzen des zweiten Stapels, um den zweiten Stapel von den Stellen der ersten Filterpixel zu entfernen und die zweiten Interferenzfilter an den Stellen der zweiten Filterpixel zu halten;
g) Aufbringen einer zweiten Isolierschicht (64) mit einer Dicke, die größer ist als die Dicke des zweiten Stapels, auf den zweiten Interferenzfiltern und zwischen den zweiten Interferenzfiltern; und
h) Ätzen mindestens eines Teils der zweiten Isolierschicht auf den zweiten Interferenzfiltern.

11. Verfahren nach Anspruch 10, wobei in Schritt a) der erste Stapel (58) auf einem Träger (32) abgeschieden wird, der mindestens einen erhabenen Bereich (70) aufweist, wobei das Verfahren in Schritt b) das Ätzen des Teils des ersten Stapels aufweist, der den erhabenen Bereich bedeckt.

12. Verfahren nach Anspruch 10 oder 11, wobei das Ätzen der ersten Isolierschicht (60) und/oder der zweiten Isolierschicht (64) einen chemischmechanischen Polierschritt aufweist.

## Claims

1. A pixelated interference filter (36) intended to rest on a support (32) and comprising, in a stacking direction:
first filter pixels (PF_{IRCUT}) having the same thicknesses, each comprising a first interference filter (IRCUT) covered with a first dielectric block (46); and
second filter pixels (PF_{IRBP}) having the same thicknesses, each comprising a second dielectric block (48), having a thickness greater than or equal to the thickness of the first interference filter, covered with a second interference filter (IRBP), having a thickness smaller than or equal to the thickness of the first dielectric block,
wherein, for at least one of the second filter pixels, the second dielectric block of the second filter pixel is interposed between the first interference filters of two first filter pixels and the second interference filter of the second filter pixel is interposed between the first dielectric blocks of the first two filter pixels,
the pixelated interference filter comprising, between each pair of first and second adjacent filter pixels, a transition area having a minimum dimension between the first filter pixel and the second filter pixel of said pair, perpendicularly to the stacking direction, smaller than 500 nm,
and wherein the pixelated interference filter comprises first and second opposite surfaces, the first surface being intended to be in contact with the support and the second surface being substantially planar.

2. The pixelated interference filter of claim 1, wherein each first interference filter (IRCUT) comprises an alternation of first dielectric layers (42) of a first dielectric material having a first refraction index in the visible range and of second dielectric layers (44) of a second dielectric material having a second refraction index in the visible range smaller than the first refraction index and wherein each second interference filter (IRBP) comprises an alternation of third dielectric layers (50) of a third dielectric material having a third refraction index in the infrared range and of fourth dielectric layers (52) of a fourth dielectric material having a fourth refraction index in the infrared range smaller than the third refraction index; or
wherein each first interference filter (IRCUT) comprises an alternation of the third dielectric layers and of the fourth dielectric layers and wherein each second interference filter (IRBP) comprises an alternation of the first dielectric layers and of the fourth dielectric layers.

3. The pixelated interference filter of claim 2, wherein the first dielectric material may be selected from the group comprising silicon nitride (SiN), hafnium oxide (HfOₓ), aluminum oxide (AlOₓ), an alloy of aluminum, oxygen, and nitrogen (AlOₓN_{y}), an alloy of silicon, oxygen, carbon, and nitrogen (SiOₓC_{y}N_{z}), silicon nitride (SiNₓ), niobium oxide (NbOₓ), tantalum oxide (TaOₓ), titanium oxide (TiOₓ), and mixtures of at least two of these compounds.

4. The pixelated interference filter of claim 2 or 3, wherein the second dielectric material and/or the fourth dielectric material may each be selected from the group comprising silicon dioxide (SiO₂), magnesium fluoride (MgF₂), silicon oxide (SiOₓ), silicon oxynitride (SiOₓN_{y}), hafnium oxide (HfOₓ), aluminum oxide (AlOₓ), a film made up of aluminum, oxygen, and nitrogen (AlOₓN_{y}), a film made up of silicon, oxygen, carbon, and nitrogen (SiOₓC_{y}N_{z}), silicon nitride (SiNₓ), and mixtures of at least two of these compounds.

5. The pixelated interference filter of any of claims 2 to 4, wherein the third dielectric material may be selected from the group comprising amorphous silicon (aSi), hydrogenated amorphous silicon (aSiH), and mixtures of these compounds.

6. An image sensor (30; 80; 85; 90; 95; 100; 105; 110; 115) comprising a support (32) and the pixelated interference filter (36) of any of claims 1 to 5 resting on the support.

7. The image sensor of claim 6, further comprising an antireflection layer (34) between the support (32) and the pixelated interference filter (36).

8. The image sensor of claim 6 or 7, comprising, for each first filter pixel (PF_{IRCUT}) and covering said first filter pixel, at least one color filter (R) capable of giving way to visible light only in a first wavelength range and one color filter (G) capable of giving way to visible light only in a second wavelength range different from the first range.

9. The image sensor of claim 8, comprising, for each color filter (R) of each first filter pixel (PF_{IRCUT}), a first lens (38) covering said color filter and comprising, for each second filter pixel (PF_{IRBP}), a second lens covering the second filter pixel.

10. A method of manufacturing the pixelated interference filter (36) of any of claims 1 to 5, comprising the successive steps of:
a) depositing, on a substrate (32), a first stack (58) of dielectric layers having the structure of the first interference filters (IRCUT);
b) etching the first stack to remove the first stack from the locations of the second filter pixels (PF_{IRBP}) and keep the first interference filters at the locations of the first filter pixels (PF_{IRCUT});
c) depositing a first insulating layer (60) having a thickness greater than the thickness of the first stack, on the first interference filters and between the first interference filters;
d) etching at least a portion of the first insulating layer on the first interference filters;
e) depositing a second stack (62) of dielectric layers having the structure of the second interference filters (IRBP);
f) etching the second stack to remove the second stack from the locations of the first filter pixels and keep the second interference filters at the locations of the second filter pixels;
g) depositing a second insulating layer (64), having a thickness greater than the thickness of the second stack, on the second interference filters and between the second interference filters; and
h) etching at least a portion of the second insulating layer on the second interference filters.

11. The method of claim 10, wherein, at step a), the first stack (58) is deposited on a support (32) comprising at least one raised area (70), the method comprising, at step b), etching the portion of the first stack covering the raised area.

12. The method of claim 10 or 11, wherein the etching of the first insulating layer (60) and/or of the second insulating layer (64) comprises a chemical-mechanical polishing step.
